# EUROPEAN PATENT SPECIFICATION

(11) **EP 3 252 908 B1**
(45) Date of publication and mention of the grant of the patent: **24.02.2021**
(21) Application number: 16742982.8
(22) Date of filing: 26.01.2016
(51) Int. Cl.: H02J 3/38, H02J 13/00, G01R 19/00, G01R 35/00, G01R 31/67

(54) **POWER MANAGEMENT DEVICE CONFIGURED TO DETERMINE MOUNTING DIRECTIONS OF CURRENT SENSORS OF A POWER GRID**
LEISTUNGSVERWALTUNGSVORRICHTUNG KONFIGURIERT UM MONTAGERICHTUNGEN VON STROMSENSOREN EINES STROMNETZES ZU BESTIMMEN
DISPOSITIF DE GESTION D'ÉNERGIE CONFIGURÉ POUR DÉTERMINER LES DIRECTIONS DE MONTAGE DES CAPTEURS DE COURANT D'UN RÉSEAU ÉLECTRIQUE

(30) Priority: 28.01.2015 JP 2015014305
(43) Date of publication of application: 06.12.2017
(73) Proprietor: Kyocera Corporation, Kyoto-shi, Kyoto 612-8501 (JP)
(72) Inventor: ENAMI, Kazuaki, Kyoto-shi Kyoto 612-8501 (JP)
(74) Representative: SSM Sandmair
(86) International application number: PCT/JP2016/000379
(87) International publication number: WO 2016/121378

(56) References cited:
- EP-A1- 2 113 979
- EP-A1- 2 395 362
- JP-A- 2009 118 673
- JP-A- 2011 160 562
- JP-A- 2013 140 110

## Description

### TECHNICAL FIELD

The present disclosure relates to a power management device and a power storage device.

### BACKGROUND

Recently, it is becoming a popular way to supply (electric) power by using power systems including distributed power supplies, such as solar cells, storage batteries, and fuel cells, installed in homes to be linked with power grids. In such a power system, a power management device is often provided. The power management device is configured to acquire (electric) current information from current sensors (which may be called Current Transformers [CTs]) mounted on power lines, in order to, for example, calculate an (electric) energy supplied from the power grid or an energy to be sold to the power grid.

Generally, power is supplied from power companies to homes by the single-phase three-wire system. In the single-phase three-wire system, an alternate current of 200 V is supplied between U phase and W phase. Furthermore, 100 V is supplied between U phase and O phase as a neutral line, and 100 V is also supplied between W phase and O phase. In the single-phase three-wire system, a current sensor is usually mounted on U phase and W phase.

Each current sensor has a correct direction. In order for the power management device to calculate an energy or the like correctly, it is necessary to install the current sensors to be mounted in the correct directions. However, in actual installation process of the current sensors, their directions might be set wrongly, and the current sensors sometimes fail to be mounted in the correct directions.

### CITATION LIST

### Patent Literature

PTL1: JP2004297959A

EP 2 395 362 A1 discloses that a distributed power supply system comprises a distributed power supply apparatus for supplying electric power to a customer load interactively with a commercial electric power utility; an internal load supplied with electric power from the commercial electric power utility; a current sensor for detecting a magnitude of a current and a direction of the current, the current being in a location closer to the commercial electric power utility than the internal load and the customer load; and a controller; wherein in a state where the distributed power supply apparatus is not generating the electric power, the controller causes the internal load to actuate, performs determination control as to an installation state of the current sensor plural times based on a value detected by the current sensor, and performs the determination control in such a manner that at least one of plural intervals at which the determination control is performed is set to an interval other than an integral multiple of another interval of the plural intervals (cf. Abstract).

EP 2 113 979 A1 discloses that a power generation system has a power generator configured to generate DC power; an electric power load; a current detector configured to detect a current flowing between a system power supply and an interconnection point; and a switch configured to switch to supply the DC power from the power generator and AC power which is fed from the system power supply through the interconnection point, to the electric power load (cf. Abstract).

### SUMMARY

### (Technical Problem)

To solve the above problem, there is proposed a private power generation system that, when any of the current sensors is mounted in the opposite direction, reverses the sign of a current value acquired from the current sensor mounted in the opposite direction for processing, thereby permitting display of correct power regardless of the mounting directions of the current sensors (refer to Patent Literature 1).

Nevertheless, the system described in Patent Literature 1 needs some time to determine whether the directions of the current sensors are correct because the system is configured to determine, individually for each of the current sensor mounted on U phase and the current sensor mounted on W phase, whether the mounting direction is correct.

The present disclosure has been conceived in view of the above problem, and the present disclosure is to provide a power management device and a power storage device that permit easy determination as to whether the current sensors are mounted in the correct directions in a short time period.

### (Solution to Problem)

The present invention is defined by the independent claim. Further embodiments of the present invention are described in the dependent claims.

### (Advantageous Effect)

The power management device and the power storage device according to some aspects of the present disclosure permit easy determination as to whether the current sensors are mounted in the correct directions in a short time period and also permit, when the current sensors are not mounted in the correct directions, appropriate correction of current values of the current sensors.

### BRIEF DESCRIPTION OF THE DRAWINGS

In the accompanying drawings:
FIG. 1 illustrates a schematic configuration of a power management system according to Embodiment 1 of the present disclosure;
FIGs. 2A and 2B illustrate examples of a relation between voltage, current, and power during power purchase and selling;
FIGs. 3A and 3B illustrate examples of current waveforms of U phase and W phase;
FIG. 4 illustrates an example of a state where unbalanced loads are connected in a power management system of FIG. 1;
FIG. 5 illustrates an example of current waveform;
FIG. 6 illustrates a schematic configuration of a power management system according to example 1 of the present disclosure;
FIG. 7 illustrates a schematic configuration of a power management system according to example 2 of the present disclosure;

### DETAILED DESCRIPTION

Embodiments of the present disclosure will be described below with reference to the drawings.

### [Embodiment 1]

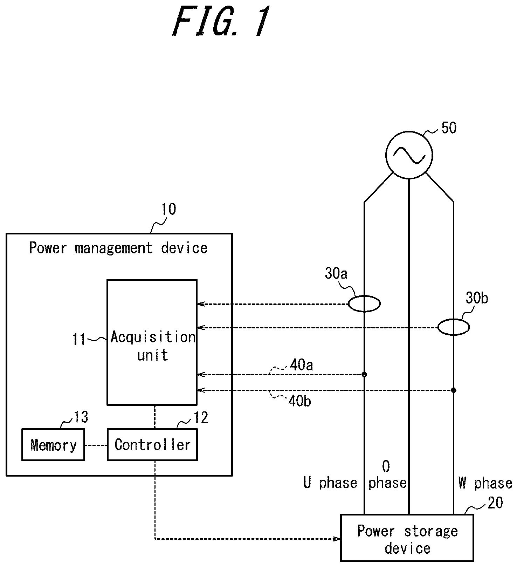

FIG. 1 illustrates a schematic configuration of a power management system according to Embodiment 1 of the present disclosure. The power management system according to Embodiment 1 includes a power management device 10, a power storage device 20, and current sensors 30a and 30b. In FIG. 1, solid lines connecting functional blocks represent power lines, and broken lines represent communication lines or signal lines. Connections indicated by the communication lines or the signal lines may be wired or wireless.

In the power management system according to Embodiment 1, a power grid 50 supplies power through single-phase three-wire lines. The single-phase three-wire lines are configured by U, W, and O phases. The U, W, and O phases may also be called the "first voltage line", the "second voltage line", and a "neutral line", respectively. U phase and W phase correspond to lines to which alternate-current voltage is applied. Hereinafter, such lines that are applied with alternate-current voltage may also be called "live lines."

The power management device 10 acquires a U-phase current value from the current sensor 30a, which is mounted on U phase, and also acquires a W-phase current value from the current sensor 30b, which is mounted on W phase. The power management device 10 also acquires a U-phase voltage value from a voltage detection line 40a, which is drawn from U phase to the power management device 10, and also acquires a W-phase voltage value from a voltage detection line 40b, which is drawn from W phase to the power management device 10. Additionally, although in the present embodiment a voltage value is acquired wiredly, the present disclosure is not limited to this embodiment. For example, a voltage value may be acquired wirelessly.

With use of the acquired U-phase and W-phase current values and U-phase and W-phase voltage values, the power management device 10 executes data processing such as calculation of power consumption.

The power management device 10 is connected to the power storage device 20 through a communication line, and the power management device 10 is configured to control operation of the power storage device 20. The power management device 10 may control the power storage device 20 to operate, for example, in a charging state or a discharging state. The power management device 10 may also control the power storage device 20 to stop operation.

A detailed description of the configuration and functions of the power management device 10 is given later below.

Although the power storage device 20 is connected to U, W, and O phases of the single-phase three-wires, charging and discharging are conducted between U phase and W phase. That is to say, during charging operation, the power storage device 20 is charged with an alternate current between U phase and W phase at 200 V. On the other hand, during discharging operation, the power storage device 20 outputs an alternate current of 200 V between U phase and W phase. Additionally, FIG. 1 illustrates an example in which the power storage device 20 is connected as a load device. However, the load device only needs to be configured to execute power supply operation by an alternate current of 200 V between U phase and W phase and to be controlled to turn on and off for the power supply operation by the power management device 10. Any load device other than the power storage device may be connected. For example, an air conditioner operated by an alternate current of 200 V may be connected.

The current sensor 30a is mounted on U phase and configured to transmit, to the power management device 10, a U-phase current value that the current sensor 30a detects. The current sensor 30b is mounted on W phase and configured to transmit, to the power management device 10, a W-phase current value that the current sensor 30b detects.

When being mounted, the current sensors 30a and 30b may be mounted in directions that permit them to detect current flowing from the power grid 50 to the power storage device 20 as positive or in directions that permit them to detect current flowing from the power storage device 20 to the power grid 50 as positive. In whichever directions the current sensors 30a and 30b may be mounted, the power management device 10 automatically determines the mounting directions of the current sensors 30a and 30b, automatically corrects the sings of current values acquired from the current sensors 30a and 30b, and executes data processing. Hereinafter, processing of the power management device 10 to automatically determine the mounting directions of the current sensors 30a and 30b is called "direction determination processing." Furthermore, processing of the power management device 10 to automatically correct the signs of current values acquired from the current sensors 30a and 30b is called "sign correction processing." Details of the "direction determination processing" and the "sign correction processing" are described later below.

Subsequently, a description is given of the configuration and functions of the power management device 10. The power management device 10 includes an acquisition unit 11, a controller 12, and a memory 13.

The acquisition unit 11 is configured to acquire a U-phase current value from the current sensor 30a and acquire a W-phasc current value from the current sensor 30b. The acquisition unit 11 is also configured to acquire a U-phase voltage value from the voltage detection line 40a and acquire a W-phase voltage value from the voltage detection line 40b.

The controller 12 is configured to control and manage the power management device 10 overall and may be a processor. The controller 12 is also configured to control operation of the power storage device 20 via the communication line. As a communication protocol for the controller 12 to control the power storage device 20, ECHONET Lite® (ECHONET Lite is a registered trademark in Japan, other countries, or both) or the like may be employed. However, ECHONET Lite® is merely an example, and other communication protocols may also be employed.

When, for example, the current sensors 30a and 30b are mounted, the controller 12 may execute the "direction determination processing" for the current sensors 30a and 30b. The controller 12 stores, in the memory 13, sign information used to correct the signs of current values acquired from the current sensors 30a and 30b. A description is given later below as to how the controller 12 executes the "direction determination processing." Additionally, the controller 12 does not necessarily need to execute the direction determination processing when the current sensors 30a and 30b are mounted. The controller 12 may execute the direction determination processing at some other opportune time. Examples of such an opportune time may include upon recovery from blackout, upon replacement of the power management device 10, and upon initialization of the power management device 10.

With use of the U-phase current value and the W-phase current value, which are acquired from the current sensors 30a and 30b, and the U-phase voltage value and the W-phase voltage value, which are acquired from the voltage detection lines 40a and 40b, the controller 12 is configured to execute data processing such as calculation of power consumption. Additionally, a U-phase voltage value (i.e., a voltage value of the first voltage line) in the present embodiment refers to a voltage between U phase and W phase. A W-phase voltage value in the present embodiment refers to a voltage between W phase and U phase. However, the present disclosure is not limited to the above embodiment. Another voltage detection line (which is not illustrated) may also be drawn from O phase, and a U-phase voltage value may be defined as a voltage between U phase and O phase, and a W-phase voltage value may be defined as a voltage between W phase and O phase. In this case also, data processing may be executed similarly. To execute various data processing, the controller 12 automatically corrects, by the "sign correction processing", the signs of current values acquired from the current sensors 30a and 30b before executing various data processing. The controller 12 is configured to execute the "sign correction processing" by multiplying the current values acquired from the current sensors 30a 30b by the sign information stored in the memory 13.

The sign information indicates "+ 1" when the current sensor 30a (or 30b) is mounted in the correct direction and indicates "- 1" when the current sensor 30a (or 30b) is mounted in the opposite direction. That is to say, when the current sensor 30a (or 30b) is mounted in the correct direction, the controller 12 uses a current value acquired from the current sensor 30a (or 30b) as it is for data processing. On the other hand, when the current sensor 30a (or 30b) is mounted in the opposite direction, the controller 12 converts the sign of a current value acquired from the current sensor 30a (or 30b) to be used for data processing. Additionally, when the current sensor 30a (or 30b) is mounted in the correct direction, the controller 12 may also multiply a current value acquired from the current sensor 30a (or 30b) by "+ 1."

The memory 13 stores therein the sign information that the controller 12 uses when executing, for the current sensors 30a and 30b, the "sign correction processing."

### (Direction Determination Processing)

Subsequently, a description is given of a concrete example of the aforementioned "direction determination processing" executed by the controller 12. When, for example, the current sensors 30a and 30b are mounted, the controller 12 may execute the "direction determination processing" by combining two types of processing. The first type of processing is "absolute direction determination processing" of determining, for one of the current sensors 30a and 30b, the mounting direction. The second type of processing is "relative direction determination processing" of determining whether a relative direction of the current sensors 30a and 30b is correct. The "absolute direction determination processing" and the "relative direction determination processing" are described below.

### (Absolute Direction Determination Processing)

The controller 12 performs the "absolute direction determination processing" on one of the current sensors 30a and 30b. The following describes an example where the "absolute direction determination processing" is executed for the current sensor 30a.

Regarding the direction of current, hereinafter, the phrase "current is flowing in a power purchase direction" is used when current is flowing from the power grid 50 toward the load device, such as the power storage device 20. On the other hand, the phrase "current is flowing in a power selling direction" is used when current is flowing toward the power grid 50.

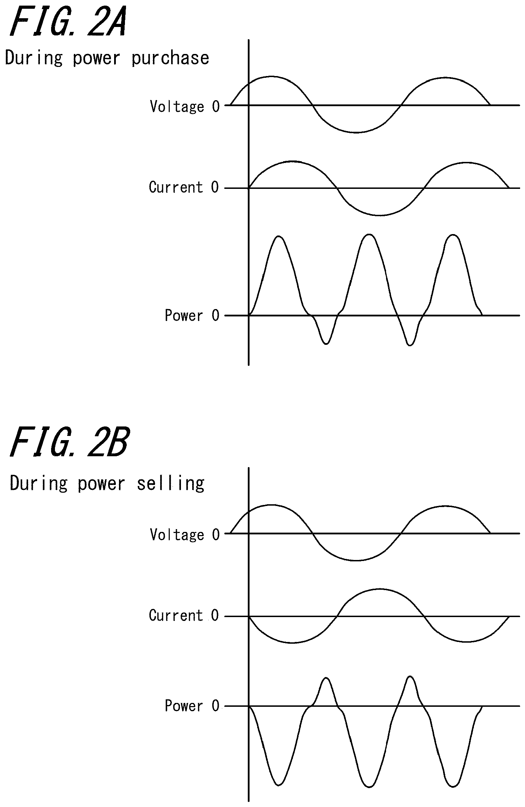

FIGs. 2A and 2B illustrate examples of a relation between voltage, current, and power during power purchase and selling. Herein, current is illustrated in FIGs. 2A and 2B, with a current value flowing from the power grid 50 to the power storage device 20 being represented as a positive value. FIG. 2A illustrates an example of the relation between voltage, current, and power during power purchase, where current is flowing in the power purchase direction. FIG. 2B illustrates an example of the relation between voltage, current, and power during power selling, where current is flowing in the power selling direction.

As illustrated in FIG. 2A, when current is flowing in the power purchase direction, voltage and current are offset in shift by not more than 90 degrees. Since power is a product of voltage and current, when voltage and current are offset in shift by less than 90 degrees, an average power value is a positive value.

On the other hand, as illustrated in FIG. 2B, when current is flowing in the power selling direction, current phase is opposite to that in cases where current is flowing in the power purchase direction. Accordingly, an average current value is a negative value.

By taking advantage of characteristics illustrated in FIGs. 2A and 2B, the controller 12 determines whether the current sensor 30a is mounted in the correct direction.

To execute the direction determination processing, the controller 12 controls the power storage device 20 to operate so that power is supplied to the power storage device 20 from the power grid 50. Then, current starts to flow through the current sensor 30a in the power purchase direction. In this state, the controller 12 multiplies a current value acquired from the current sensor 30a and a voltage value acquired from the voltage detection line 40a to obtain an average value. When the obtained average value is a positive value, the controller 12 determines that the current sensor 30a is mounted in the correct direction. When the obtained average value is a negative value, the controller 12 determines that the current sensor 30a is mounted in the opposite direction.

The controller 12 may also determine whether the current sensor 30a is mounted in the correct direction by other methods than the above determination method using an average power value. For example, the controller 12 may determine the direction of the current sensor 30a from a difference in phase between voltage and current, instead of determining it by calculating an average power value. In this case, when a difference in phase between a current value acquired from the current sensor 30a and a voltage value acquired from the voltage detection line 40a is less than 90 degrees, the controller 12 determines that the current sensor 30a is mounted in the correct direction. On the other hand, when the difference in phase is not within the range of less than 90 degrees, the controller 12 determines that the current sensor 30a is mounted in the opposite direction.

The controller 12 determines, for one of the current sensors 30a and 30b, whether the mounting direction is correct according to one of the above two methods.

### (Relative Direction Determination Processing)

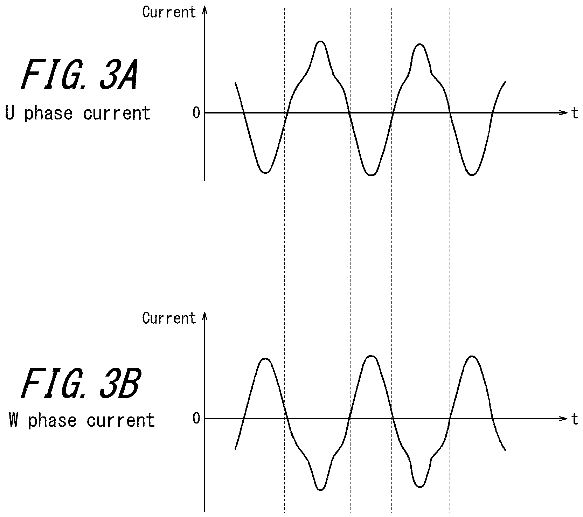

The "relative direction determination processing" is described next. To start with, a description is given of general characteristics of polarities of current flowing in U phase and W phase in the single-phase three-wire lines, before operation of the controller 12 is explained. As illustrated by examples of FIGs. 3A and 3B, current flowing in U phase and current flowing in W phase always have reverse polarities except for zero crossing points. This relation always applies regardless of, for example, whether it is in a power selling state or a power purchase state, whether the load device is 100 V system or 200 V system, and whether the frequency of alternate-current voltage is 60 Hz or 50 Hz. However, although having reverse polarities, current flowing in U phase and current flowing in W phase do not always have the same absolute value and waveform.

By taking advantage of the above characteristics, the controller 12 determines whether the mounting direction of the current sensor 30a and the mounting direction of the current sensor 30b are relatively correct. Herein, when the mounting direction of the current sensor 30a and the mounting direction of the current sensor 30b are relatively correct, it corresponds to one of the following two states: the one state in which both the current sensors 30a and 30b are mounted in the correct directions; and the other state in which both the current sensors 30a and 30b are mounted in the opposite directions.

The controller 12 compares an instantaneous current measurement value (which is called the first measurement value or the first instantaneous value) acquired from the current sensor 30a and an instantaneous current measurement value (which is called the second measurement value or the second instantaneous value) acquired from the current sensor 30b. When the compared values have the reversed polarity relation, the controller 12 determines that the mounting direction of the current sensor 30a and the mounting direction of the current sensor 30b are relatively correct. On the other hand, as a result of comparison of an instantaneous current measurement value acquired from the current sensor 30a and an instantaneous current measurement value acquired from the current sensor 30b, the compared values may turn out to have the same polarity relation. In this case, the controller 12 determines that the mounting direction of the current sensor 30a and the mounting direction of the current sensor 30b are relatively incorrect.

Since being capable of making the above determination based on instantaneous current values acquired from the current sensors 30a and 30b, the controller 12 executes the "relative direction determination processing" in a shorter time period compared with the "absolute direction determination processing." The reason is that the "absolute direction determination processing" is not instantaneous but involves the calculation of an average power value or the calculation of a difference in phase between voltage and current, thus requiring, for example, several seconds to several minutes of time.

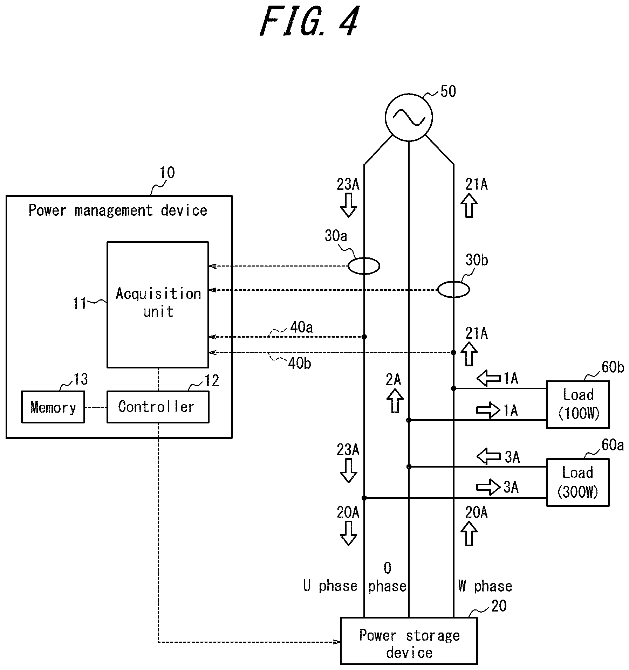

Herein, with reference to FIG.4, a description is given of the fact that, even when a load connected between U phase and O phase and a load connected between W phase and O phase are unbalanced, current flowing in U phase and current flowing in W phase has the reversed polarity relation.

In the example illustrated in FIG. 4, a load 60a of 300 W is connected between U phase and O phase, and a load 60b of 100 W is connected between W phase and O phase. Furthermore, a current of 20 A flows through the 2 kW power storage device 20.

In the example illustrated in FIG. 4, a current of 23 A flows from the power grid 50 in U phase, and 20 A of the current flows through the power storage device 20, and the remaining 3 A flows through the load 60a. After flowing through the power storage device 20, 20 A returns to the power grid 50 via W phase. Furthermore, after flowing through the load 60a, 3 A returns to O phase. However, 1A in the returned 3A flows to the load 60b. After flowing through the load 60b, 1A returns to the power grid 50 via W phase. Consequently, in W phase, 20A from the power storage device 20, plus, 1A from the load 60b, that is to say, 21 A flows to the power grid 50.

Thus, in the example illustrated in FIG. 4, 23 A flows in the power purchase direction in a mounting position of the current sensor 30a in U phase, and 21 A flows in the power selling direction in a mounting position of the current sensor 30b in W phase. In this way, even when the load connected between U phase and O phase and the load connected between W phase and O phase are unbalanced, current flowing in U phase and current flowing in W phase have reverse polarities. Accordingly, the present embodiment permits determination even when current flowing through the current sensor 30a and current flowing through the current sensor 30b do not have the same absolute value and waveform. The present embodiment therefore facilitates determination even when the states of the loads arc changed, compared with the method of subjecting both the current sensors 30a and 30b to the absolute direction determination processing.

### (Direction Determination Processing Flow Executed by Power Management Device)

Subsequently, a description is given of a direction determination processing flow executed for the current sensors 30a and 30b by the power management device 10 in the present embodiment. Note that, although the description is given below of an example in which the "absolute direction determination processing" is executed for the current sensor 30a, the "absolute direction determination processing" may be executed for the current sensor 30b according to the same flow.

The controller 12 transmits, to the power storage device 20, an instruction to start to charge, thereby controlling the power storage device 20 to start charging operation.

The acquisition unit 11 acquires a U-phase current value from the current sensor 30a and acquires a U-phase voltage value from the voltage detection line 40a.

Based on the U-phase current value acquired from the current sensor 30a and the U-phase voltage value acquired from the voltage detection line 40a, the controller 12 executes the "absolute direction determination processing."

When determining that the mounting direction of the current sensor 30a is correct as a result of the "absolute direction determination processing", the controller 12 stores, in the memory 13, "+ 1" as the sign information used to correct the sign of a current value acquired from the current sensor 30a. When determining that the mounting direction of the current sensor 30a is opposite as a result of the "absolute direction determination processing", the controller 12 stores, in the memory 13, "- 1" as the sign information used to correct the sign of a current value acquired from the current sensor 30a.

The acquisition unit 11 acquires an instantaneous U-phase current value from the current sensor 30a and acquires an instantaneous W-phase current value from the current sensor 30b.

Based on the instantaneous U-phase current value acquired from the current sensor 30a and the instantaneous W-phase current value acquired from the current sensor 30b, the controller 12 executes the "relative direction determination processing."

When determining that the mounting direction of the current sensor 30a and the mounting direction of the current sensor 30b after the absolute direction determination processing are relatively correct as a result of the "relative direction determination processing", the controller 12 stores, in the memory 13, "+ 1" as the sign information used to correct the sign of a current value acquired from the current sensor 30b. Additionally, when the mounting direction of the current sensor 30a and the mounting direction of the current sensor 30b are relatively correct, it encompasses the following two states. The first state refers to the state where, when the sign information for the current sensor 30a that is stored in the memory 13 according to the result of the "absolute direction determination processing" is "+ 1", the instantaneous current value acquired from the current sensor 30b before correction has a reverse polarity with respect to the instantaneous current value acquired from the current sensor 30a before correction. The second state refers to the state where, when the sign information for the current sensor 30a that is stored in the memory 13 according to the result of the "absolute direction determination processing" is "- 1", the instantaneous current value acquired from the current sensor 30b before correction has the same polarity with respect to the instantaneous current value acquired from the current sensor 30a before correction. When determining that the mounting direction of the current sensor 30a and the mounting direction of the current sensor 30b after the absolute direction determination processing are relatively incorrect as a result of the "relative direction determination processing", the controller 12 stores, in the memory 13, "- 1" as the sign information used to correct the sign of a current value acquired from the current sensor 30b. Additionally, when the mounting direction of the current sensor 30a and the mounting direction of the current sensor 30b are relatively incorrect, it encompasses the following two states. The first state refers to the state where, when the sign information for the current sensor 30a that is stored in the memory 13 according to the result of the "absolute direction determination processing" is "+ 1", the instantaneous current value acquired from the current sensor 30b before correction has the same polarity with respect to the instantaneous current value acquired from the current sensor 30a before correction. The second state refers to the state where, when the sign information for the current sensor 30a that is stored in the memory 13 according to the "absolute direction determination processing" is "- 1", the instantaneous current value acquired from the current sensor 30b before correction has a reverse polarity with respect to the instantaneous current value acquired from the current sensor 30a before correction.

In the subsequent various data processing, the controller 12 executes the sign correction processing on current values acquired from the current sensors 30a and 30b in accordance with the sign information stored in the memory 13 before executing various data processing.

### (Threshold Setting during Execution of Relative Direction Determination Processing)

When, during execution of the relative direction determination processing by the controller 12, the instantaneous current values acquired from the current sensors 30a and 30b are near the zero crossing points, it is sometimes impossible to determine the polarities of the instantaneous current values correctly due to, for example, errors of the current sensors 30a and 30b. To prevent the above situation, the controller 12 may be configured to determine the relative mounting direction when absolute values of the instantaneous current values are greater than a predetermined threshold Ith.

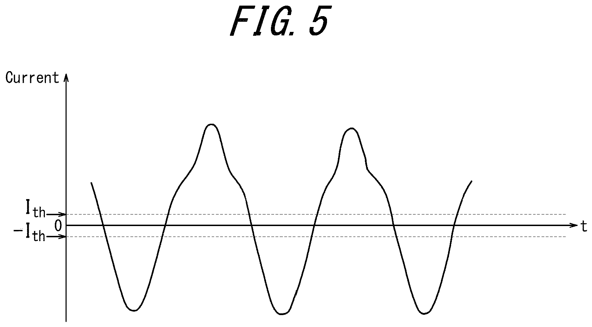

In an example illustrated in FIG. 5, when the instantaneous current values are within the range from - Ith to Ith, the controller 12 acquires the instantaneous current values again at another time. On the other hand, when the instantaneous current values are greater than Ith, the controller 12 executes the relative direction determination processing. The threshold Ith may be set, for example, based on tolerance of the current sensors 30a and 30b. For example, when the current sensors 30a and 30b are specified to measure up to 40 A, with a tolerance of 5 %, an error of 2 A arises. In consideration of the error, the threshold Ith may also set to be 2 A or more.

In this way, according to the present embodiment, the "absolute direction determination processing" is executed for only one of the current sensors 30a and 30b. Moreover, the "relative direction determination processing", which permits determination in a short time period by using the instantaneous current values, is combined to the "absolute direction determination processing." Thus, the mounting directions of the current sensors 30a and 30b are determined. The above processing facilitates determination as to whether the current sensors 30a and 30b are mounted in the correct directions in a short time period and also permits, with use of a result of the determination, correction of the signs of current values acquired from the current sensors 30a and 30b.

### Example 1

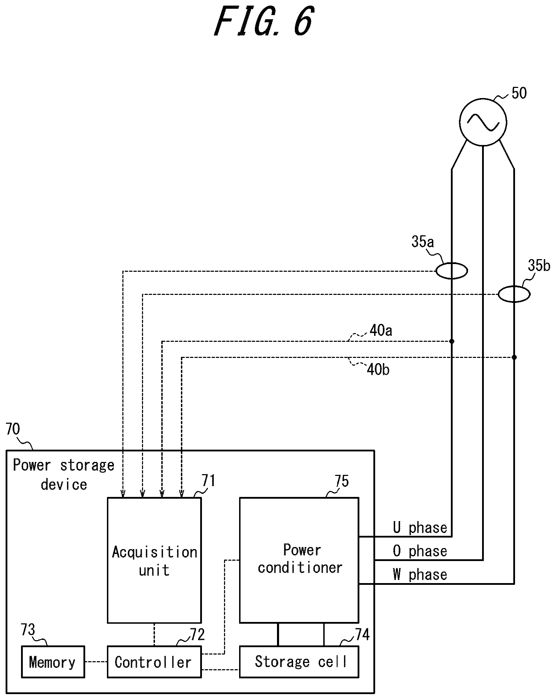

FIG. 6 illustrates a schematic configuration of a power management system according to Example 1 of the present disclosure. The power management system according to Example 1 includes a power storage device 70 and current sensors 35a and 35b. In FIG. 6, solid lines connecting functional blocks represent power lines, and broken lines represent communication lines or signal lines. Connection indicated by the communication lines or the signal lines may be wired or wireless. In Example 1, a description of features that are common or similar to those in Embodiment 1 is omitted as needed, and a description is given mainly of differences from Embodiment 1.

The configuration of Example 1 assumes the power storage device 70, which is provided under terms of a contract specifying no use of push-up effect. Herein, the "terms of a contract specifying no use of push-up effect" refer to the terms of a contract specifying that the power storage device shall not be discharged to supply power to the loads when power generated by a solar photovoltaic device is being sold to the electric company (power grid). Note that the solar photovoltaic device connected to the single-phase three-wires is not illustrated in FIG. 6.

The current sensors 35a and 35b serve to monitor a reverse flow to the power grid 50 to prevent the power storage device 70 from creating push-up effect.

The power storage device 70 includes an acquisition unit 71, a controller 72, a memory 73, a storage cell 74, and a power conditioner 75. The acquisition unit 71, the controller 72, and the memory 73 respectively correspond to the acquisition unit 11, the controller 12, and the memory 13, which are included in the power management device 10 of Embodiment 1. The acquisition unit 71, the controller 72, and the memory 73 operate similarly to the acquisition unit 11, the controller 12, and the memory 13, and a detailed description thereof is omitted.

The storage cell 74 is configured to discharge to supply direct-current power to the power conditioner 75. The storage cell 74 is also configured to be charged with direct-current power supplied from the power conditioner 75.

The power conditioner 75 is configured to convert direct-current power discharged from the storage cell 74 into alternate-current power. The power conditioner 75 is also bidirectional. The power conditioner 75 is also configured to convert alternate-current power supplied from the single-phase three-wires into direct-current power to supply the direct-current power to the storage cell 74, thereby charging the storage cell 74.

Example 1 differs from Embodiment 1 in that the acquisition unit 71, the controller 72, and the memory 73, which respectively correspond to the acquisition unit 11, the controller 12, and the memory 13 of Embodiment 1, are included in the power storage device 70.

When, for example, the current sensors 35a and 35b are mounted, the power storage device 70 may execute the direction determination processing for the current sensors 35a and 35b.

When the power storage device 70 executes the direction determination processing, the controller 72 controls the storage cell 74 and the power conditioner 75 to start charging operation before the execution of the direction determination processing. The subsequent processing is the same as that in Embodiment 1.

In this way, according to the present embodiment, the "absolute direction determination processing" is executed for only one of the current sensors 35a and 35b. Moreover, the "relative direction determination processing", which permits determination in a short time period through measurement of the instantaneous current values, is combined to the "absolute direction determination processing." Thus, the mounting directions of the current sensors 35a and 35b are determined. The above processing facilitates determination as to whether the current sensors 35a and 35b, which serve to monitor a reverse flow, are mounted in the correct directions in a short time period and also permits the power storage device 70 to correct, with use of a result of the determination, the signs of current values acquired from the current sensors 35a and 35b and monitor a reverse flow.

### Example 2

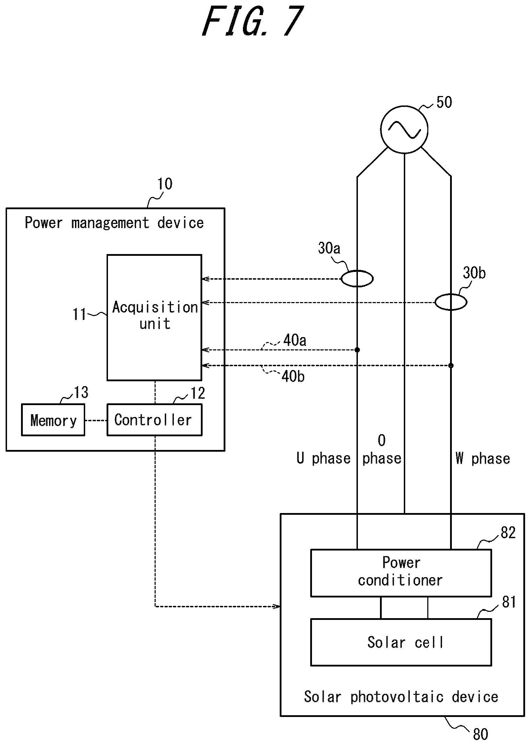

FIG. 7 illustrates a schematic configuration of a power management system according to Example 2 of the present disclosure. The power management system according to Example 2 includes the power management device 10, the current sensors 30a and 30b, and a solar photovoltaic device 80. In FIG. 7, solid lines connecting functional blocks represent power lines, and broken lines represent communication lines or signal lines. Connection indicated by the communication lines or the signal lines may be wired or wireless. In Example 2, a description of features that are common or similar to those in Embodiment 1 is omitted as needed, and a description is given mainly of differences from Embodiment 1.

Example 2 differs from Embodiment 1 in that the solar photovoltaic device 80 is provided instead of the power storage device 20.

The solar photovoltaic device 80 includes a solar cell 81 and a power conditioner 82. The solar cell 81 is configured to convert photovoltaic energy into direct-current power. The power conditioner 82 is configured to convert direct-current power supplied from the solar cell 81 into alternate-current power. The power conditioner 82 is configured to supply an alternate-current power of 200 V between U phase and W phase.

Generally, the power conditioner 82 included in the solar photovoltaic device 80 may be the one that draws power from the solar cell 81 or the one that draws power from the power grid 50. The power conditioner 82 according to the present embodiment is the one that draws power from the power grid 50.

### (Direction Determination Processing Flow Executed by Power Management Device When Current Flows in Power Purchase Direction)

The controller 12 of the power management device 10 transmits, to the power conditioner 82, which is included in the solar photovoltaic device 80, an instruction to "power-on." At this time, when the solar photovoltaic device 80 is generating power, the controller 12 transmits, to the power conditioner 82, an instruction to "stop output" to prevent a reverse current flow into the power grid 50. The subsequent processing is the same as that in Embodiment 1.

### (Direction Determination Processing Flow Executed by Power Management Device When Current Flows in Power Selling Direction)

In this situation, the direction determination processing is executed after any load (which is not illustrated) except for the solar photovoltaic device 80 is stopped. Any load (which is not illustrated) except for the solar photovoltaic device 80 may be stopped, for example, by turning off a branch breaker.

The power management device 10 operates the solar photovoltaic device 80 in a power generating state to create a current flow in the power selling direction, that is to say, a reverse current flow, toward the power grid 50.

The subsequent processing is substantially the same as that in Embodiment 1, except for the way of determination in the "absolute direction determination processing."

When making a determination with use of an average power value, the controller 12 multiplies a current value acquired from the current sensor 30a and a voltage value acquired from the voltage detection line 40a in the state where current flows in the power selling direction to obtain an average value. When the obtained average value is a positive value, the controller 12 determines that the current sensor 30a is mounted in the opposite direction. When the obtained average value is a negative value, the controller 12 determines that the current sensor 30a is mounted in the correct direction.

Alternatively, when making a determination with use of a difference in phase between current and voltage, the controller 12 determines as follows. That is to say, when the difference in phase between a current value acquired from the current sensor 30a and a voltage value acquired from the voltage detection line 40a in the state where current flows in the power selling direction is less than 90 degrees, the controller 12 determines that the current sensor 30a is mounted in the opposite direction. On the other hand, when the difference in phase is not within the range of less than 90 degrees, the controller 12 determines that the current sensor 30a is mounted in the correct direction.

Thus, even in the state where the solar photovoltaic device 80 is generating power and where current is flowing in the power selling direction toward the power grid 50, the present embodiment facilitates determination as to whether the current sensors 30a and 30b are mounted in the correct directions in a short time period and also permits correction of the signs of current values acquired from the current sensors 30a and 30b with use of a result of the determination.

### REFERENCE SIGNS LIST

- 10: Power management device
- 11: Acquisition unit
- 12: Controller
- 13: Memory
- 15: Power management device
- 16: Acquisition unit
- 17: Controller
- 18: Memory
- 20: Power storage device
- 25: Power storage device
- 30a, 30b: Current sensor
- 35a, 35b: Current sensor
- 37a, 37b, 37c: Current sensor
- 40a, 40b: Voltage detection line
- 47a, 47b, 47c: Voltage detection line
- 50: Power grid
- 60a, 60b: Load
- 70: Power storage device
- 71: Acquisition unit
- 72: Controller
- 73: Memory
- 74: Storage cell
- 75: Power conditioner
- 80: Solar photovoltaic device
- 90: Power storage device
- 91: Acquisition unit
- 92: Controller
- 93: Memory
- 94: Storage cell
- 95: Power conditioner

## Claims

1. A power management device (10) configured
to acquire current values from a plurality of current sensors (30a, 30b) mounted to two live lines to which voltage is applied in a single-phase three-wire power grid, the single-phase three-wire power grid including a first voltage line and a second voltage line as the live lines and a neutral line, and
to execute data processing using the acquired current values, and further configured to control operation of a load device,
the power management device (10) comprising:
an acquisition unit (11) configured to acquire a first voltage value referring to a voltage between the first voltage line and the second voltage line, and a second voltage value referring to a voltage between the second voltage line and the first voltage line and from the current sensors (30a, 30b) the current values of the live lines; and
a controller (12) configured to determine the mounting directions of a first current sensor (30a) of the plurality of current sensors, the first current sensor mounted on the first voltage line and a second current sensor (30b) of the plurality of current sensors, the second current sensor mounted on the second voltage line and,
based on the determined mounting directions, correct the signs of the current values acquired from the first current sensor (30a) and the second current sensor (30b) for the data processing,
the correction of the signs of the current values acquired from the first current sensor (30a) and the second current sensor (30b) being based on
the mounting direction of the first current sensor (30a) that is determined from the acquired current value and voltage value of the first voltage line and the controlled operation state of the load device ; and further based on
correctness and incorrectness of a relative mounting direction of the first current sensor (30a) and the second current sensor (30b) that is determined from a first measurement value of current of the first voltage line acquired from the first current sensor (30a) and a second measurement value of current of the second voltage line acquired from the second current sensor (30b),
wherein the controller (12) is configured to compare
the first measurement value of current of the first voltage line,
the sign of the first measurement value having been corrected in accordance with the determined mounting direction of the first current sensor (30a), and
the second measurement value of current of the second voltage line,
and, the controller is configured when the corrected first measurement value and the second measurement value have a reverse polarity relation, to determine that the relative mounting direction of the first current sensor (30a) and the second current sensor (30b) is correct, and to maintain the sign of the current value acquired from the second current sensor (30b) as it is,
and, when the corrected first measurement value and the second measurement value have a same polarity relation, to determine that the relative mounting direction of the first current sensor (30a) and the second current sensor (30b) is incorrect, and to correct the sign of the current value acquired from the second current sensor (30b) by reversing the sign.

2. The power management device (10) of claim 1, wherein the controller (12) is configured to determine correctness and incorrectness of the relative mounting direction of the first current sensor (30a) and the second current sensor (30b) when absolute values of the measurement values of current acquired from the first current sensor (30a) and the second current sensor (30b) are greater than a predetermined threshold.

3. The power management device (10) of claim 1 or 2, wherein the controller (12) is configured to operate the load device to cause a current flow to the power grid in a power purchase direction, calculate an average value by multiplying the acquired current value and voltage value of the first voltage line, and determine that the mounting direction of the first current sensor (30a) is correct when the average value is positive.

4. The power management device (10) of claim 1 or 2, wherein the controller (12) is configured to operate the load device to cause a current flow to the power grid in a power selling direction, calculate an average value by multiplying the acquired current value and voltage value of the first voltage line, and determine that the mounting direction of the first current sensor (30a) is correct when the average value is negative.

## Patentansprüche

1. Leistungsverwaltungsvorrichtung (10), konfiguriert
zum Erfassen von Stromwerten von mehreren Stromsensoren (30a, 30b), die an zwei stromführenden Leitungen angebracht sind, an die Spannung in einem einphasigen Dreileiter-Stromnetz angelegt wird, wobei das einphasige Dreileiter-Stromnetz eine erste Spannungsleitung enthält und eine zweite Spannungsleitung als stromführende Leitung und eine neutrale Leitung, und
zum Ausführen einer Datenverarbeitung unter Verwendung der erfassten aktuellen Werte, und ferner konfiguriert, um den Betrieb einer Lastvorrichtung zu steuern;
wobei die Leistungsverwaltungsvorrichtung (10) umfasst:
eine Erfassungseinheit (11), die konfiguriert ist zum Erfassen eines ersten Spannungswerts, der sich auf eine Spannung zwischen der ersten Spannungsleitung und der zweiten Spannungsleitung bezieht, und eines zweiten Spannungswerts, der sich auf eine Spannung zwischen der zweiten Spannungsleitung und der ersten Spannungsleitung bezieht, und der Stromwerte der stromführenden Leitungen von den Stromsensoren (30a, 30b); und
eine Steuerung (12), konfiguriert zum
Bestimmen der Montagerichtungen eines ersten Stromsensors (30a) aus der Mehrzahl der Stromsensoren, der an der ersten Spannungsleitung montiert ist, und eines zweiten Stromsensors (30b) aus der Mehrzahl der Stromsensoren, der an der zweiten Spannungsleitung montiert ist, und zum
Korrigieren der Vorzeichen der vom ersten Stromsensor (30a) und vom zweiten Stromsensor (30b) erfassten Stromwerte für die Datenverarbeitung, basierend auf den ermittelten Einbaurichtungen,
wobei die Korrektur der Vorzeichen der vom ersten Stromsensor (30a) und vom zweiten Stromsensor (30b) erfassten Stromwerte basiert auf
der Einbaurichtung des ersten Stromsensors (30a), die aus dem erfassten Stromwert und Spannungswert der ersten Spannungsleitung und dem gesteuerten Betriebszustand der Lastvorrichtung bestimmt wird; und ferner basiert auf
Richtigkeit und Unrichtigkeit einer relativen Einbaurichtung des ersten Stromsensors (30a) und des zweiten Stromsensors (30b), die aus einem ersten Messwert des Stroms der ersten Spannungsleitung bestimmt wird, der vom ersten Stromsensor (30a) erfasst wurde, und einem zweiten Messwert des Stroms der zweiten Spannungsleitung, der vom zweiten Stromsensor (30b) erfasst wurde,
wobei die Steuerung (12) konfiguriert ist zum Vergleichen
des ersten Messwerts des Stroms der ersten Spannungsleitung,
des Vorzeichens des ersten Messwertes, das gemäß der ermittelten Einbaurichtung des ersten Stromsensors (30a) korrigiert wurde, und
des zweiten Messwerts des Stroms der zweiten Spannungsleitung,
und wobei, wenn der korrigierte erste Messwert und der zweite Messwert eine umgekehrte Polaritätsbeziehung haben, die Steuerung konfiguriert ist zum Bestimmen, dass die relative Einbaurichtung des ersten Stromsensors (30a) und des zweiten Stromsensors (30b) korrekt ist, und um das Vorzeichen des Stromwertes, der vom zweiten Stromsensor (30b) erfasst wurde, so wie es ist beizubehalten,
und, wenn der korrigierte erste Messwert und der zweite Messwert die gleiche Polaritätsbeziehung haben, zum Bestimmen, dass die relative Einbaurichtung des ersten Stromsensors (30a) und des zweiten Stromsensors (30b) unrichtig ist,
und zum Korrigieren des Vorzeichens des vom zweiten Stromsensor (30b) erfassten Stromwerts durch Umkehren des Vorzeichens.

2. Leistungsverwaltungsvorrichtung (10) nach Anspruch 1, bei der die Steuerung (12) konfiguriert ist, um die Richtigkeit und Unrichtigkeit der relativen Einbaurichtung des ersten Stromsensors (30a) und des zweiten Stromsensors (30b) zu bestimmen, wenn absolute Werte der vom ersten Stromsensor (30a) und vom zweiten Stromsensor (30b) erfassten Messwerte des Stroms größer als ein vorbestimmter Schwellenwert sind.

3. Leistungsverwaltungsvorrichtung (10) nach Anspruch 1 oder 2, wobei die Steuerung (12) konfiguriert ist, um die Lastvorrichtung zu betreiben, um einen Stromfluss zum Stromnetz in einer Strom-Einkaufsrichtung zu bewirken, um einen Durchschnittswert durch Multiplizieren des erfassten Stromwerts und Spannungswerts der ersten Spannungsleitung zu berechnen, und um zu bestimmen, dass die Einbaurichtung des ersten Stromsensors (30a) korrekt ist, wenn der Durchschnittswert positiv ist.

4. Leistungsverwaltungsvorrichtung (10) nach Anspruch 1 oder 2, wobei die Steuerung (12) konfiguriert ist, um die Lastvorrichtung zu betreiben, um einen Stromfluss zum Stromnetz in einer Strom-Verkaufsrichtung zu bewirken, um einen Durchschnittswert durch Multiplizieren des erfassten Stromwerts und Spannungswerts der ersten Spannungsleitung zu berechnen, und um zu bestimmen, dass die Einbaurichtung des ersten Stromsensors (30a) korrekt ist, wenn der Durchschnittswert negativ ist.

## Revendications

1. Dispositif de gestion d'énergie (10) configuré
pour acquérir des valeurs de courant auprès d'une pluralité de capteurs de courant (30a, 30b) montés sur deux lignes sous tension auxquelles une tension appliquée dans un réseau électrique trifilaire monophasé, le réseau électrique trifilaire monophasé comportant une première ligne de tension et une deuxième ligne de tension en tant que lignes sous tension et une ligne neutre, et
pour exécuter un traitement de données à l'aide des valeurs de courant acquises, et configuré en outre pour commander un fonctionnement d'un dispositif charge,
le dispositif de gestion d'énergie (10) comprenant :
une unité d'acquisition (11) configurée pour acquérir une première valeur de tension en référence à une tension entre la première ligne de tension et la deuxième ligne de tension, et une deuxième valeur de tension en référence à une tension entre la deuxième ligne de tension et la première ligne de tension et auprès des capteurs de courant (30a, 30b) les valeurs de courant des lignes sous tension ; et
un dispositif de commande (12) configuré pour
déterminer les directions de montage d'un premier capteur de courant (30a) de la pluralité de capteurs de courant, le premier capteur de courant étant monté sur la première ligne de tension, et d'un deuxième capteur de courant (30b) de la pluralité de capteurs de courant, le deuxième capteur de courant étant monté sur la deuxième ligne de tension et,
sur la base des directions de montage déterminées, corriger les signes des valeurs de courant acquises auprès du premier capteur de courant (30a) et du deuxième capteur de courant (30b) pour le traitement de données,
la correction des signes des valeurs de courant acquises auprès du premier capteur de courant (30a) et du deuxième capteur de courant (30b) étant basée sur
la direction de montage du premier capteur de courant (30a) qui est déterminée à partir de la valeur de courant et la valeur de tension acquises de la première ligne de tension et de l'état de fonctionnement commandé du dispositif charge ; et en outre basée sur
le caractère correct ou incorrect d'une direction de montage relative du premier capteur de courant (30a) et du deuxième capteur de courant (30b) qui est déterminé à partir d'une première valeur de mesure de courant de la première ligne de tension acquise auprès du premier capteur de courant (30a) et d'une deuxième valeur de mesure de courant de la deuxième ligne de tension acquise auprès du deuxième capteur de courant (30b),
dans lequel le dispositif de commande (12) est configuré pour comparer
la première valeur de mesure de courant de la première ligne de tension,
le signe de la première valeur de mesure ayant été corrigé en conformité avec la direction de montage déterminée du premier capteur de courant (30a), et
la deuxième valeur de mesure de courant de la deuxième ligne de tension,
et le dispositif de commande est configuré, lorsque la première valeur de mesure corrigée et la deuxième valeur de mesure ont une relation de polarité inverse, pour déterminer que la direction de montage relative du premier capteur de courant (30a) et du deuxième capteur de courant (30b) est correcte, et pour maintenir tel quel le signe de la valeur de courant acquise auprès du deuxième capteur de courant (30b),
et, lorsque la première valeur de mesure corrigée et la deuxième valeur de mesure ont une relation de même polarité, pour déterminer que la direction de montage relative du premier capteur de courant (30a) et du deuxième capteur de courant (30b) est incorrecte, et pour corriger le signe de la valeur de courant acquise auprès du deuxième capteur de courant (30b) en inversant le signe.

2. Dispositif de gestion d'énergie (10) selon la revendication 1, dans lequel le dispositif de commande (12) est configuré pour déterminer le caractère correct et le caractère incorrect de la direction de montage relative du premier capteur de courant (30a) et du deuxième capteur de courant (30b) lorsque des valeurs absolues des valeurs de mesure acquises auprès du premier capteur de courant (30a) et du deuxième capteur de courant (30b) sont supérieures à un seuil prédéterminé.

3. Dispositif de gestion d'énergie (10) selon la revendication 1 ou 2, dans lequel le dispositif de commande (12) est configuré pour faire fonctionner le dispositif charge afin de provoquer la circulation d'un courant jusqu'au réseau électrique dans une direction d'achat d'énergie, calculer une valeur moyenne en multipliant la valeur de courant et la valeur de tension acquises de la première ligne de tension, et déterminer que la direction de montage du premier capteur de courant (30a) est correcte lorsque la valeur moyenne est positive.

4. Dispositif de gestion d'énergie (10) selon la revendication 1 ou 2, dans lequel le dispositif de commande (12) est configuré pour faire fonctionner le dispositif charge afin de provoquer la circulation d'un courant jusqu'au réseau électrique dans une direction de vente d'énergie, calculer une valeur moyenne en multipliant la valeur de courant et la valeur de tension acquises de la première ligne de tension, et déterminer que la direction de montage du premier capteur de courant (30a) est correcte lorsque la valeur moyenne est négative.
